# EUROPEAN PATENT APPLICATION

(11) **EP 4 822 907 A1**
(43) Date of publication of application: **14.10.2026**
(21) Application number: 26170205.4
(22) Date of filing: 01.04.2026
(51) Int. Cl.: H01R 12/78, H01R 12/59, H05K 1/11, H01R 11/01

(54) **VARIABLE PITCH CONNECTOR**

(30) Priority: 07.04.2025 CN 202520641818 U
(71) Applicant: Tyco Electronics (Shanghai) Co., Ltd., Pilot Free Trade Zone Shanghai 200131 (CN)
(72) Inventor: Zhu, Jianghua, Suzhou, 215121 (CN); Zhou, Xiao, Shanghai, 200233 (CN); Yuan, Wei, Shanghai, 200233 (CN)
(74) Representative: Grünecker Patent- und Rechtsanwälte PartG mbB

(57) **Abstract**

Disclosed is a variable pitch connector (10) including: two flexible circuit boards (100) stacked on top of each other, each flexible circuit board including multiple first electrical contacts (110) provided at a first end (101) and a corresponding number of multiple second electrical contacts (120) provided at a second end (102); wherein, a first pitch (P1) between any two adjacent first electrical contacts (110) is greater than a second pitch (P2) between any two adjacent second electrical contacts (120); and the first electrical contact (110) is used to be connected with a connection terminal (11), while the second electrical contact (120) is used to be connected with a wire (31) in a flat cable (30).

## Description

### CROSS-REFERENCE TO RELATED APPLICATION

This application claims the benefit of Chinese Patent Application No. CN 202520641818.5 filed on April 7, 2025 in the China National Intellectual Property Administration, the whole disclosure of which is incorporated herein by reference.

### FIELD OF THE DISCLOSURE

Embodiments of the present disclosure relate to the technical field of a battery of an electric vehicle, and in particular to, a variable pitch connector suitable for a battery pack.

### DESCRIPTION OF THE RELATED ART

With the development of the new energy industry, the sales volume of electric vehicles has been growing steadily in the market, and the importance of the reliability of battery packs is self-evident. As the requirement for the pitch of flat cables arranged inside the battery packs continues to decrease (e.g., transitioning from 2.0 mm, 1.8 mm to 1.5 mm, or even 1.0 mm), the terminal pitch of connectors also needs to be reduced accordingly. However, reducing the terminal pitch may result in the electrical distance between adjacent terminals failing to meet safety requirements, posing risks of short circuits or breakdowns. Existing connectors generally adopt a constant pitch design, which cannot simultaneously meet the requirements of small-pitch flat cables and large-pitch terminals.

In addition, a solution capable of integrating an electronic element (such as a fuse) into the connector to provide circuit protection is lacked in the related art, which leads to insufficient safety and difficult maintenance.

### SUMMARY

An object of the present disclosure is to address at least one of the above problems and/or defects existing in the related art.

According to an aspect of the present disclosure, there is provided a variable pitch connector including:
two flexible circuit boards stacked on top of each other, each flexible circuit board including multiple first electrical contacts provided at a first end and a corresponding number of multiple second electrical contacts provided at a second end; wherein,
a first pitch between any two adjacent first electrical contacts is greater than a second pitch between any two adjacent second electrical contacts; and
the first electrical contact is used to be connected with a connection terminal, while the second electrical contact is used to be connected with a wire in a flat cable.

According to an exemplary embodiment of the present disclosure, the multiple first electrical contacts and the multiple second electrical contacts are provided on a surface of each flexible circuit board away from the other flexible circuit board.

According to an exemplary embodiment of the present disclosure, the two flexible circuit boards are integrally formed into a mutually stacked by means of folding in half.

According to an exemplary embodiment of the present disclosure, each first electrical contact is connected to the corresponding second electrical contact via a lead.

According to an exemplary embodiment of the present disclosure, an electronic element for circuit protection is provided on at least one lead.

According to an exemplary embodiment of the present disclosure, the first pitch between any two adjacent first electrical contacts is the same; and the second pitch between any two adjacent second electrical contacts is the same.

According to an exemplary embodiment of the present disclosure, the first end and the second end are opposite to each other; the multiple first electrical contacts located at the first end are arranged in parallel with each other; and the multiple second electrical contacts located at the second end are arranged in parallel with each other.

According to an exemplary embodiment of the present disclosure, each first electrical contact is adopted to be connected by means of crimping, and each second electrical contact is adopted to be connected by means of soldering.

According to an exemplary embodiment of the present disclosure, the multiple connection terminals in the variable pitch connector are crimped at the multiple first electrical contacts, respectively, and multiple wire in the flat cable are respectively soldered and fixed at the multiple second electrical contacts by dispensing glue.

According to an exemplary embodiment of the present disclosure, the variable pitch connector further includes a housing, wherein the connection terminal is provided within the housing.

The variable pitch connector provided by the various aforementioned exemplary embodiments of the present disclosure adopts a double-layer stacked flexible circuit board (FPC) structure, and by the design of the electrical contacts and the leads on the flexible circuit board, the second pitch between the second electrical contacts on the circuit board adapted to be connected with the flat cable wires is reduced without changing the first pitch between the first electrical contacts on the circuit board adapted to be connected with the connection terminals, achieving smooth connection between the small-pitch flat cable wires and the large-pitch connection terminals, thereby satisfying electrical safety requirements. Moreover, with the provision of the electronic element (such as the fuse) for circuit protection on the circuit board, the battery is protected more safely, facilitating customer's layout and simplifying maintenance. In addition, FPC enables automatic crimping and soldering of the terminals, improving production efficiency.

Other objectives and advantages of the present disclosure will become apparent from the following description of the present disclosure with reference to the accompanying drawings, which will also help to provide a comprehensive understanding of the present disclosure.

### BRIEF DESCRIPTION OF THE DRAWINGS

Fig. 1 is a schematic perspective structural view showing a connection assembly including a variable pitch connector according to an exemplary embodiment of the present disclosure; and
Fig. 2 is a schematic perspective structural view showing the variable pitch connector according to an exemplary embodiment of the present disclosure.

### DETAILED DESCRIPTION OF EXEMPLARY EMBODIMENTS

The technical solution of the present disclosure is further specifically described below through embodiments and in combination with the accompanying drawings. In the description, the same or similar parts are indicated by the same or similar reference numerals. The description of each of embodiments of the present disclosure hereinafter with reference to the accompanying drawings is intended to explain the general inventive concept of the present disclosure and should not be construed as a limitation on the present disclosure.

In addition, in the following detailed description, for the sake of explanation, numerous specific details are set forth in order to provide a thorough understanding of the disclosed embodiments. It will be apparent, however, that one or more embodiments may also be practiced without these specific details. In other instances, well-known structures and devices are illustrated schematically in order to simplify the drawing.

The present disclosure relates to a variable pitch connector, which is particularly suitable for high-voltage wire connection in a battery pack of an electric vehicle.

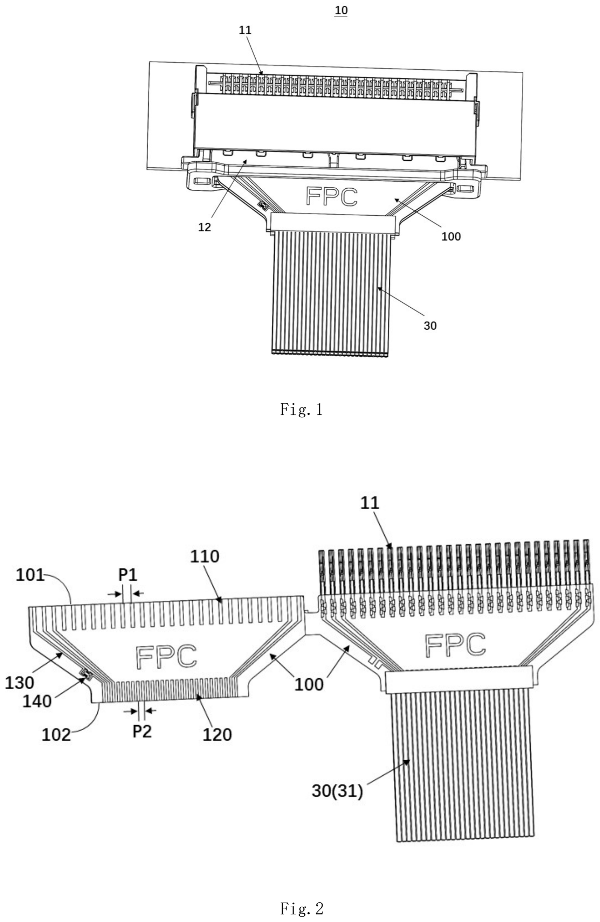

Fig. 1 is a schematic perspective structural view showing a connection assembly including a variable pitch connector according to an exemplary embodiment of the present disclosure; and Fig. 2 is a schematic perspective structural view showing the variable pitch connector according to an exemplary embodiment of the present disclosure. In the exemplary embodiments shown in Figs. 1 and 2, a double-layer stacked flexible circuit board (FPC) is taken as an example for illustration. It should be noted that the present disclosure is not limited to the flexible circuit boards, but can also be applied to printed circuit boards (PCB). It should also be noted that, for the sake of clarity, the double-layer flexible circuit board shown in Fig. 2 is in an unfolded state, and the flexible circuit board on the left side of the figure is not yet connected to the flat cable wire and the connection terminal. In addition, also for the sake of clarity, all leads 130 connecting the first electrical contacts and the corresponding second electrical contacts are not shown in Fig. 2.

Referring to Figs. 1 and 2, according to the exemplary embodiments of the present disclosure, there is provided a variable pitch connector 10. The variable pitch connector 10 includes a housing 12 and multiple connection terminals 11 provided within the housing 12. As shown in Fig. 1, the variable pitch connector 10 further includes two flexible circuit boards 100 stacked on top of each other. As shown in Fig. 2, each flexible circuit board 100 includes multiple first electrical contacts 110 provided at a first end 101 and a corresponding number of multiple second electrical contacts 120 provided at a second end 102, wherein the first electrical contact 110 is used to be connected with the connection terminal 11, and the second electrical contact 120 is used to be connected with a wire 31 in a flat cable 30. According to the design concept of the present disclosure, the two flexible circuit boards 100 adopt a mutually stacked structure, and in each flexible circuit board 100, a first pitch P1 between any two adjacent first electrical contacts 110 is greater than a second pitch P2 between any two adjacent second electrical contacts 120. In addition, in each flexible circuit board 100, each first electrical contact 110 is connected to the corresponding second electrical contact 120 via a single lead 130. According to the present disclosure, the circuit board 100 may be made of a polyimide (PI) substrate, and the electrical contacts 110, 120 and the leads 130 may be formed by copper plating on a surface of the substrate.

As shown in Figs. 1 and 2, according to the exemplary embodiments of the present disclosure, the two flexible circuit boards 100 are integrally formed into the mutually stacked structure by means of folding in half. The multiple first electrical contacts 110 and the multiple second electrical contacts 120 are provided on a surface of each flexible circuit board 100 away from the other flexible circuit board 100. In this way, each electrical contact 110, 120 is located on the outward-facing surface of the flexible circuit board assembly adopting the mutually stacked structure.

As shown in Figs. 1 and 2, according to the exemplary embodiments of the present disclosure, the first pitch P1 between any two adjacent first electrical contacts 110 is the same; and the second pitch P2 between any two adjacent second electrical contacts 120 is the same. The first pitch P1 is greater than the second pitch P2. For example, when P1 is maintained at 2.0 mm, P2 may be 1.0 mm, or even 0.8 mm. With such a configuration, the second pitch between the second electrical contacts on the circuit board adapted to be connected with the flat cable wire is reduced without changing the first pitch between the first electrical contacts on the circuit board adapted to be connected with the connection terminals, achieving smooth connection between small-pitch flat cable wires and large-pitch connection terminals and meeting electrical safety requirements.

As shown in Figs. 1 and 2, according to the exemplary embodiments of the present disclosure, the first end 101 and the second end 102 are opposite to each other. That is, the multiple first electrical contacts 110 located at the first end 101 are arranged in parallel with each other; and the multiple second electrical contacts 120 located at the second end 102 are arranged in parallel with each other. In addition, the lead 130 adopt a serpentine routing to avoid signal reflection caused by right-angle bends.

As shown in Figs. 1 and 2, according to the exemplary embodiments of the present disclosure, an electronic element 140 for circuit protection is provided on at least one lead 130. For example, in the illustrated embodiment, the lead 130 provided with the electronic element 140 for circuit protection may be the outermost lead among the multiple leads. In other embodiments, the lead 130 provided with the electronic element 140 for circuit protection may also be any one of the multiple leads. The electronic element for circuit protection may be, for example, a fuse. With the provision of the electronic element (such as the fuse) for circuit protection on the circuit board, the battery is protected more safely, facilitating customer's layout and simplifying maintenance. In addition, FPC enables automatic crimping and soldering of the terminals, improving production efficiency.

As shown in Figs. 1 and 2, according to the exemplary embodiments of the present disclosure, each first electrical contact 110 is adapted to be connected by means of crimping, and each second electrical contact 120 is adapted to be connected by means of soldering. That is, the multiple connection terminals 11 in the variable pitch connector 10 are crimped (e.g., by means of the terminals directly piercing the electrical contacts to achieve mutual contact) at the multiple first electrical contacts 110, respectively, and the multiple wire 31 in the flat cable 30 are respectively soldered and fixed at the multiple second electrical contacts 120 by dispensing glue.

It should be noted that, although the exemplary embodiments of the present disclosure are described by taking the double-layer flexible circuit board (FPC) as an example, according to some non-illustrated exemplary embodiments of the present disclosure, the circuit board 100 may include a single printed circuit board (PCB), and multiple first electrical contacts 110 and multiple second electrical contacts 120 are provided on each of the opposite surfaces of the printed circuit board.

The variable pitch connector provided by the various aforementioned exemplary embodiments of the present disclosure adopts a double-layer stacked flexible circuit board (FPC) structure, and by the design of the electrical contacts and the leads on the flexible circuit board, the second pitch between the second electrical contacts on the circuit board adapted to be connected with the flat cable wires is reduced without changing the first pitch between the first electrical contacts on the circuit board adapted to be connected with the connection terminals, achieving smooth connection between the small-pitch flat cable wires and the large-pitch connection terminals, thereby satisfying electrical safety requirements. Moreover, with the provision of the electronic element (such as the fuse) for circuit protection on the circuit board, the battery is protected more safely, facilitating customer's layout and simplifying maintenance. In addition, FPC enables automatic crimping and soldering of terminals, improving production efficiency.

It should be appreciated by those skilled in the art that the above embodiments are intended to be illustrative, and many modifications may be made to the above embodiments by those skilled in the art. Further, various structures described in various embodiments may be freely combined with each other without conflicting in configuration or principle.

Although the present disclosure has been described hereinbefore in detail with reference to the accompanying drawings, the disclosed embodiments in the accompanying drawings are intended to illustrate the preferred embodiments of the present disclosure by way of example, and should not be construed as limitation to the present disclosure.

Although some embodiments of the present disclosure have been shown and described, it would be appreciated by those skilled in the art that changes or modification may be made to these embodiments without departing from the principles and spirit of the general inventive concept, the scope of which is defined in claims and their equivalents.

It should be noted that, the word "comprise" or "include" doesn't exclude other elements or steps, and the word "a" or "an" doesn't exclude more than a plurality. In addition, any reference numerals in the claims should not be interpreted as the limitation to the scope of the present disclosure.

## Claims

1. A variable pitch connector (10) comprising:
two flexible circuit boards (100) stacked on top of each other, each flexible circuit board comprising multiple first electrical contacts (110) provided at a first end (101) and a corresponding number of multiple second electrical contacts (120) provided at a second end (102); wherein,
a first pitch (P1) between any two adjacent first electrical contacts (110) is greater than a second pitch (P2) between any two adjacent second electrical contacts (120); and
the first electrical contact (110) is used to be connected with a connection terminal (11), while the second electrical contact (120) is used to be connected with a wire (31) in a flat cable (30).

2. The variable pitch connector (10) according to claim 1, wherein,
the multiple first electrical contacts (110) and the multiple second electrical contacts (120) are provided on a surface of each flexible circuit board away from the other flexible circuit board.

3. The variable pitch connector (10) according to claim 1, wherein,
the two flexible circuit boards (100) are integrally formed into a mutually stacked by means of folding in half.

4. The variable pitch connector (10) according to claim 1, wherein,
each first electrical contact (110) is connected to the corresponding second electrical contact (120) via a lead (130).

5. The variable pitch connector (10) according to claim 1, wherein,
an electronic element (140) for circuit protection is provided on at least one lead (130).

6. The variable pitch connector (10) according to claim 1, wherein,
the first pitch (P1) between any two adjacent first electrical contacts (110) is the same;
and the second pitch (P2) between any two adjacent second electrical contacts (120) is the same.

7. The variable pitch connector (10) according to claim 1, wherein,
the first end (101) and the second end (102) are opposite to each other;
the multiple first electrical contacts (110) located at the first end (101) are arranged in parallel with each other; and
the multiple second electrical contacts (120) located at the second end (102) are arranged in parallel with each other.

8. The variable pitch connector (10) according to claim 1, wherein,
each first electrical contact (110) is adopted to be connected by means of crimping, and each second electrical contact (120) is adopted to be connected by means of soldering.

9. The variable pitch connector (10) according to claim 8, wherein,
the multiple connection terminals (11) in the variable pitch connector (10) are crimped at the multiple first electrical contacts (110), respectively, and multiple wire (31) in the flat cable (30) are respectively soldered and fixed at the multiple second electrical contacts (120) by dispensing glue.

10. The variable pitch connector (10) according to any one of claims 1 to 9, wherein,
the variable pitch connector (10) further comprises a housing (12), wherein the connection terminal (11) is provided within the housing (12).
